# EUROPÄISCHE PATENTANMELDUNG

(11) **EP 1 918 945 A2**
(43) Veröffentlichungstag der Anmeldung: **07.05.2008**
(21) Anmeldenummer: 07117209.2
(22) Anmeldetag: 26.09.2007
(51) Int. Cl.: H01F 5/02, H01F 27/29

(54) **Spulenkörper für induktive Bauelemente**

(30) Priorität: 06.11.2006 DE 102006052212
(71) Anmelder: Siemens Aktiengesellschaft Österreich, 1210 Wien (AT)
(72) Erfinder: Appel, Wilhelm, 2136, Laa a. d. Thaya (AT); Eichhorner, Bernhard, 1210, Wien (AT); Schönleitner, Arnold, 1130, Wien (AT); Peprny, Wolfgang, 1210, Wien (AT)

(57) **Zusammenfassung**

Die Erfindung bezieht sich auf Spulenkörper für induktive Bauelemente mit Anschlüssen (3) für Leiterplatten (1,2), bei denen Anschlüsse (3a,3b) auf gegenüberliegenden Seiten des Spulenkörpers vorgesehen sind. Dadurch kann eine Spulenbaugruppe bestehend aus zwei Leiterplatten (1,2) und einem induktiven Bauelement mit einem erfindungsgemäßen Spulenkörper und einem im Spulenkörper gehaltenen, magnetischen Kern (6), sowie zumindest einer Wicklung (5) entlang eines Wickelabschnittes des Spulenkörpers, verwirklicht werden, bei dem die Anschlüsse (3a,3b) jeweils einer Seite des Bauelements mit einer der Leiterplatten (1,2) verbunden sind.

## Beschreibung

Die Erfindung bezieht sich auf einen Spulenkörper für induktive Bauelemente mit Anschlüssen für Leiterplatten, gemäß dem Oberbegriff von Anspruch 1. Die Erfindung umfasst des Weiteren ein induktives Bauelement mit einem erfindungsgemäßen Spulenkörper, sowie einem im Spulenkörper gehaltenen, magnetischen Kern, und zumindest einer Wicklung entlang eines Wickelabschnittes des Spulenkörpers. Die Erfindung umfasst ferner eine Spulenbaugruppe mit zwei Leiterplatten und einem induktiven Bauelement mit einem erfindungsgemäßen Spulenkörper.

Durch die Entwicklung immer leistungsfähigerer und kompakterer elektronischer Schaltungen werden zunehmend elektronische Schaltungen auf Leiterplatten verwirklicht, in denen Ströme und/oder Spannungen bei hohen Frequenzen und hoher Leistung geschaltet werden müssen. Die entsprechenden induktiven Komponenten bilden dabei einen wesentlichen Bestandteil solcher Schaltungen, wobei insbesondere die erforderliche Größe des induktiven Bauelements einen wesentlichen Kostenfaktor darstellt, da in der Regel teure Ferritmaterialien erforderlich sind, und außerdem ein großes Bauvolumen auch ein entsprechendes Volumen auf der Leiterplatte einnimmt, was die Packungsdichte verringert.

Des Weiteren ist bei induktiven Bauelementen, etwa Transformatoren, in denen zumindest auf einer Seite hohe Spannungen auftreten können, eine entsprechend hohe Isolationsfestigkeit zu fordern, die dann wiederum zu einer entsprechenden Vergrößerung des Bauvolumens führt. Speziell bei Netzteilen ist die Anforderung einer Reduzierung des Bauvolumens eines der wesentlichen Zielsetzungen. Netzteile mit hohen Versorgungsspannungen sind hier besonders schwierig optimierbar, da entsprechende Distanzkriterien eingehalten werden müssen, also die Distanz stromführender Pfade nicht beliebig verringert werden kann. Dadurch ist insbesondere bei induktiven Komponenten ein Reduzieren der Baugröße schwer möglich, etwa aufgrund eines erforderlichen Mindestabstandes benachbarter Anschlüsse ("Pins"). Daher wurden etwa bei Transformatoren die Primär- und Sekundärwicklungen immer auf der gleichen Seite ausgeführt. Herkömmliche Spulenkörper unterstützen daher auch ausschließlich eine solche Bauweise.

Des Weiteren ist es bekannt, mehrere Leiterplatten zu verwenden, welche in die Hauptplatine eingesteckt werden. Dadurch wird zwar eine höhere Packungsdichte auf der Hauptplatine erreicht, ein Reduzieren der Baugröße etwa induktiver Bauelemente ist aber auch durch eine solche Maßnahme nicht möglich.

Es ist daher das Ziel der Erfindung, eine Verringerung der Baugröße herkömmlicher Bauelemente für Leiterplatten zu ermöglichen, insbesondere für induktive Bauelemente. Dadurch sollen die Packungsdichte dieser Bauelemente auf Leiterplatten erhöht und die Baukosten verringert werden können. Des Weiteren soll das Bauteilverhalten hinsichtlich seiner Isolationsfestigkeit erhöht werden. Diese Ziele werden durch die Maßnahmen von Anspruch 1 erreicht.

Anspruch 1 sieht einen Spulenkörper für induktive Bauelemente mit Anschlüssen für Leiterplatten vor, bei denen Anschlüsse auf gegenüberliegenden Seiten des Spulenkörpers vorgesehen sind. Mittels eines solchen Spulenkörpers ist es möglich, völlig neue, schaltungstechnische Ansätze auf Leiterplatten zu realisieren. Bei dem erfindungsgemäßen Spulenkörper sind die Anschlüsse ("Pins") nicht nur auf einer Seite ausgeführt, sondern auch auf der gegenüberliegenden Seite. Dadurch ist es möglich, den Spulenkörper bzw. das darauf aufbauende, induktive Bauelement zwischen zwei Leiterplatten zu befestigen. Der Energiefluss bewegt sich somit etwa bei einem Transformator mit dem erfindungsgemäßen Spulenkörper von den Eingangsanschlüssen auf einer der beiden Leiterplatten über den primären Zwischenkreis weiter über den Transformator auf die Sekundärseite zu den dort befindlichen Ausgangsanschlüssen auf der zweiten Leiterplatte. Der Aufbau kann somit wesentlich kompakter gestaltet werden. Des Weiteren werden durch die erfindungsgemäße Ausführung des Spulenkörpers sehr gute Trennmöglichkeiten von Primärseite und Sekundärseite möglich. Der Spulenkörper kann außerdem gleichzeitig als Signal übertragendes Element zwischen den beiden Leiterplatten eingesetzt werden. Dabei muss es sich nicht unbedingt um die Transformatorbezogenen Signale handeln, da es auch möglich ist, den Spulenkörper mit zusätzlichen Verbindungselementen auszustatten, die Transformator-unabhängige Signale übertragen. Ein weiterer Vorteil erfindungsgemäßer Spulenkörper besteht im geringeren Übersprechen von Signalen von der Primärseite auf die Sekundärseite aufgrund der verbesserten räumlichen Trennung.

Anspruch 2 bezieht sich auf ein induktives Bauelement mit einem erfindungsgemäßen Spulenkörper, sowie einem im Spulenkörper gehaltenen, magnetischen Kern, und zumindest einer Wicklung entlang eines Wickelabschnittes des Spulenkörpers, wobei vorgesehen ist, dass die Endabschnitte der zumindest einen Wicklung in den Anschlüssen des Spulenkörpers zur Herstellung einer leitfähigen Verbindung mit einer Leiterplatte gehalten sind. Bei einem solchen Bauelement kann gemäß Anspruch 3 vorgesehen sein, dass es sich bei dem induktiven Bauelement um einen Transformator mit einer Primärwicklung und einer Sekundärwicklung handelt, wobei die Anschlüsse einer Seite der Primärwicklung zugeordnet sind, und die Anschlüsse der gegenüberliegenden Seite der Sekundärwicklung. Dabei ist es gemäß Anspruch 4 vorteilhaft, wenn der magnetische Kern als E-Kern aus einem Ferrit ausgeführt ist.

Anspruch 5 bezieht sich auf eine Spulenbaugruppe mit zwei Leiterplatten und einem induktiven Bauelement mit einem erfindungsgemäßen Spulenkörper, wobei die Anschlüsse jeweils einer Seite des Bauelements mit einer der Leiterplatten verbunden sind.

Anspruch 6 bezieht sich auf ein Netzteil, bei dem es sich auch um ein Schaltnetzteil handeln kann, mit einer erfindungsgemäßen Spulenbaugruppe, und Anspruch 7 auf einen Wechselrichter.

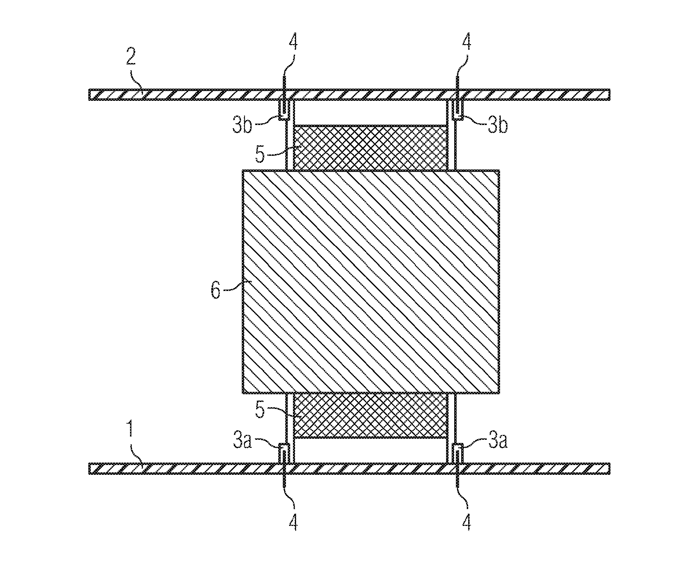

Die Erfindung wird im Folgenden anhand eines Ausführungsbeispieles mittels der beiliegenden Fig. 1 näher erläutert, die eine schematische Darstellung einer Seitenansicht einer erfindungsgemäßen Spulenbaugruppe zeigt.

Die Fig. 1 zeigt eine erste Leiterplatte 1 und eine zweite Leiterplatte 2, die in herkömmlicher Weise der mechanischen Befestigung und der elektrischen Verbindung von elektronischen Bauteilen dienen. Zwischen den beiden Leiterplatten 1,2 ist ein induktives Bauelement, in der Fig. 1 etwa ein Transformator, angeordnet, das über Anschlüsse 3 an den Leiterplatten 1,2 befestigt ist. Die Anschlüsse 3 sind in der dargestellten Ausführungsform an Lötstifte 4 gelegt, und können so direkt auf den Leiterplatten 1,2 verlötet werden. Alternativ wären auch entsprechende Kontaktflächen zur Oberflächenmontage denkbar.

Die Anschlüsse 3a definieren die Primärseite des Transformators, und die auf der gegenüberliegenden Seite angeordneten Anschlüsse 3b die Sekundärseite. In den Anschlüssen 3a sind die Endabschnitte der Primärwicklung 5a zur Herstellung einer leitfähigen Verbindung mit der Leiterplatte 1 gehalten, und in den Anschlüssen 3b die Endabschnitte der Sekundärwicklung 5b zur Herstellung einer leitfähigen Verbindung mit der Leiterplatte 2. Die Primärwicklung 5a und die Sekundärwicklung 5b sind in der Fig. 1 nicht unterscheidbar als Wicklung 5 dargestellt.

Die Wicklungen 5 sind von einem magnetischen Kern 6 umschlossen, bei dem es sich vorzugsweise um einen weichmagnetischen Werkstoff handelt, etwa ein Ferrit. Ferrite sind ferromagnetische Keramiken, die besonders bei kleineren Transformatoren und höheren Frequenzen verwendet werden. Es wäre aber auch möglich, etwa amorphe Metallbandkerne oder Pulverkerne zu verwenden. Da die Änderung der Magnetfeldstärke ein wesentlicher Bestandteil der Wirkweise des Transformators ist, kann ein Transformator bei erhöhter Frequenz des Erregerstromes auch mehr Leistung übertragen. Daher können mit steigender Frequenz die Windungszahl und/oder das Kernvolumen abnehmen, ohne dass sich die Spannung verändert. Damit wird eine wesentlich höhere Leistungsdichte erreicht, sodass etwa Schaltnetzteile erheblich kleiner gebaut werden können. In der Ausführungsform gemäß Fig. 1 ist der magnetische Kern 6 außerdem aus zwei E-Kernen zusammengesetzt. Eine solche Ausführung eignet sich insbesondere für hohe Leistungen und hat außerdem den Vorteil, zwei preisgünstige Standard-E-Kerne einzusetzen, anstelle einer einzelnen, größeren Sonderbauform.

Der Spulenkörper ist ein aus nichtmagnetischem Material, meist aus Kunststoff, bestehendes Formteil, welches den magnetischen Kern 6 und die Wicklungen 5 aufnimmt, ihnen mechanische Stabilität gibt und nötigenfalls auch voneinander isoliert. Der Spulenkörper sieht auch die Anschlüsse 3 vor, die erfindungsgemäß auf gegenüberliegenden Seiten des Spulenkörpers vorgesehen sind. Im Zuge des Fertigungsprozesses wird der magnetische Kern 6 im Spulenkörper befestigt, und die Wicklungen 5 entlang eines Wickelabschnittes des Spulenkörpers aufgebracht. Die Endabschnitte der Wicklungen 5 sind danach in den Anschlüssen 3 des Spulenkörpers zur Herstellung einer leitfähigen Verbindung mit den Leiterplatten 1,2 gehalten.

Der Energiefluss bewegt sich somit von den Eingangsanschlüssen 3a auf der ersten Leiterplatte 1 über den primären Zwischenkreis weiter über den Transformator auf die Sekundärseite zu den dort befindlichen Ausgangsanschlüssen 3b auf der zweiten Leiterplatte 2. Durch die verbesserte räumliche Trennung wird somit eine Verringerung der Baugröße ermöglicht, insbesondere für induktive Bauelemente. Dadurch können die Packungsdichte dieser Bauelemente auf den Leiterplatten 1,2 erhöht und die Baukosten verringert werden. Auch das Bauteilverhalten hinsichtlich der Isolationsfestigkeit dieser Bauelemente wird somit auf einfache Weise erhöht. Besonders vorteilhaft ist die Verwendung solcher erfindungsgemäßen Spulenbaugruppe dabei in Netzteilen, etwa Schaltnetzteilen, oder in Wechselrichter.

## Patentansprüche

1. Spulenkörper für induktive Bauelemente mit Anschlüssen (3) für Leiterplatten (1,2), **dadurch gekennzeichnet, dass** Anschlüsse (3a,3b) auf gegenüberliegenden Seiten des Spulenkörpers vorgesehen sind.

2. Induktives Bauelement mit einem Spulenkörper gemäß Anspruch 1, sowie einem im Spulenkörper gehaltenen, magnetischen Kern (6), und zumindest einer Wicklung (5) entlang eines Wickelabschnittes des Spulenkörpers, **dadurch gekennzeichnet, dass** die Endabschnitte der zumindest einen Wicklung (5) in den Anschlüssen (3) des Spulenkörpers zur Herstellung einer leitfähigen Verbindung mit einer Leiterplatte (1,2) gehalten sind.

3. Induktives Bauelement nach Anspruch 2, **dadurch gekennzeichnet, dass** es sich bei dem induktiven Bauelement um einen Transformator mit einer Primärwicklung (5a) und einer Sekundärwicklung (5b) handelt, wobei die Anschlüsse (3a) einer Seite der Primärwicklung (5a) zugeordnet sind, und die Anschlüsse (3b) der gegenüberliegenden Seite der Sekundärwicklung (5b).

4. Induktives Bauelement nach Anspruch 3, **dadurch gekennzeichnet, dass** der magnetische Kern (6) als E-Kern aus einem Ferrit ausgeführt ist.

5. Spulenbaugruppe mit zwei Leiterplatten (1,2) und einem induktiven Bauelement nach einem der Ansprüche 2 bis 4,
**dadurch gekennzeichnet, dass** die Anschlüsse (3a,3b) jeweils einer Seite des Bauelements mit einer der Leiterplatten (1,2) verbunden sind.

6. Netzteil mit einer Spulenbaugruppe nach Anspruch 5.

7. Wechselrichter mit einer Spulenbaugruppe nach Anspruch 5.
